# EUROPEAN PATENT APPLICATION

(11) **EP 2 645 114 A2**
(43) Date of publication of application: **02.10.2013**
(21) Application number: 13161209.5
(22) Date of filing: 26.03.2013
(51) Int. Cl.: G01R 19/00, H02H 3/00

(54) **Current measurement and comparing assembly for a power distribution system and method for measuring and comparing current**

(30) Priority: 27.03.2012 US 201213431403
(71) Applicant: Hamilton Sundstrand Corporation, Windsor Locks, CT 06096-1010 (US)
(72) Inventor: Simper, Norbert J., 86657 Bissingen (DE); Seidel, Rainer, 86874 Tussenhausen (DE); Maier, Josef, 86754 Munningen (DE); Krenz, Michael, Roscoe, Illinois 61073 (US); Wagner, Carl A., Beloit, Wisconsin 53511 (US); Wavering, Jeffrey T., Rockford, Illinois 61109 (US); Foster, Michael William, Rockford, Illinois 61107 (US); Brantl, Peter, 86742 Fremdingen (DE)
(74) Representative: Tomlinson, Kerry John

(57) **Abstract**

A current measurement and comparing assembly (12) for a power distribution system (10) includes a solid state contactor module (16) having a control section (18) and a power section (20), wherein the power section includes at least one solid state switch (14). Also included is a current sensor (34) disposed in the control section (18) and in operable communication with the at least one solid state switch (14), wherein the current sensor (34) distributes current data to a switch control (30) configured to control the at least one solid state switch (14) and distributes current data to a current measurement and comparison circuit (50) via line (52).

## Description

### BACKGROUND OF THE INVENTION

The present invention relates to power distribution systems, and more particularly to measuring and comparing electrical current passing through such power distribution systems and a method for measuring and comparing the current.

Current transformers are typically employed in aircraft primary power distribution systems to monitor the integrity of high electric current paths. The current transformers are expensive, heavy and require extra wiring. The large, external current transformers are mounted over portions of high power wiring harnesses and require amplifiers for operation. In an effort to detect wiring failure, two current transformers are typically needed, with one on each end of a conductor, to measure the possible difference between current flowing in and out of the harness section, thereby doubling the effort needed.

### BRIEF DESCRIPTION OF THE INVENTION

According to one embodiment, a current measurement and comparing assembly for a power distribution system includes a solid state contactor module having a control section and a power section, wherein the power section includes at least one solid state switch. Also included is a current sensor disposed in the control section and in operable communication with the at least one solid state switch, wherein the current sensor distributes current data to a switch control configured to control the at least one solid state switch and distributes current data to a current measurement and comparison circuit.

According to another embodiment, a method of measuring and comparing current of a power distribution system is provided. The method includes integrating a current sensor within a control section of a solid state contactor module having at least one solid state switch; distributing current data to a switch control configured to control the at least one solid state switch; distributing current data via an input line to a current measurement and comparison circuit; and comparing the current data received from the input line to a first summed current differential signal from at least one downstream solid state switch, wherein a current difference is detected.

### BRIEF DESCRIPTION OF THE DRAWINGS

The subject matter which is regarded as the invention is particularly pointed out and distinctly claimed in the claims at the conclusion of the specification. The foregoing and other features and advantages of the invention are apparent from the following detailed description taken in conjunction with the accompanying drawings in which:

FIG. 1 is a schematic illustration of a solid state contactor module having a control section and a power section;

FIG. 2 is a schematic illustration of a current measurement and comparing circuit; and

FIG. 3 is a flow diagram illustrating a method of measuring and comparing electric current.

### DETAILED DESCRIPTION

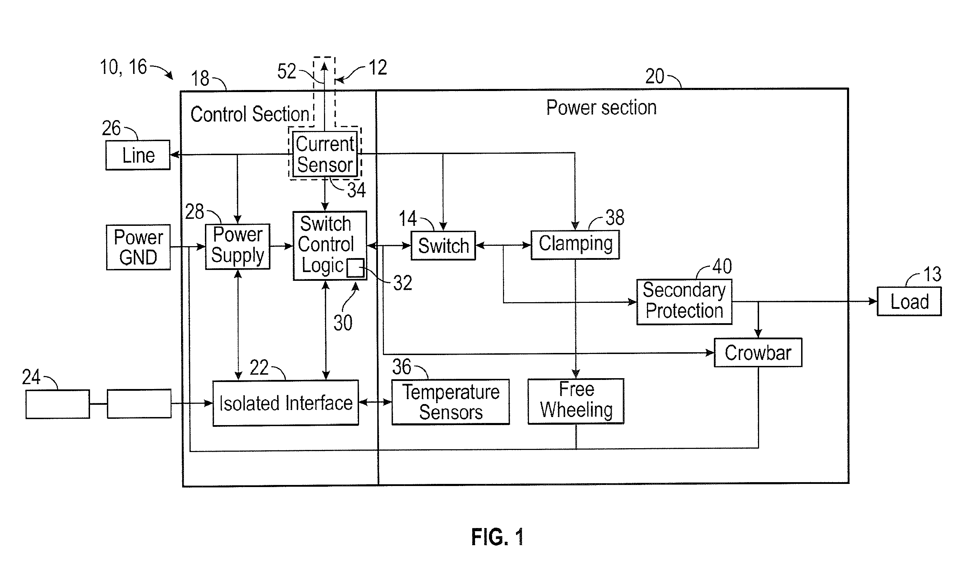

Referring to FIG. 1, a power distribution system 10 having a current measurement and comparing assembly 12 is schematically illustrated. The power distribution system 10 may be employed in a variety of vehicles, including an aircraft requiring electrical power distribution to a plurality of different loads, one of which is represented with reference numeral 13. The power distribution system 10 comprises a plurality of solid state switches 14 and the power distribution system 10 may be represented as a number of single solid state switches connected in series or parallel.

FIG. 1 specifically illustrates a solid state contactor module 16 in which a contactor has both a control section 18 and a power section 20. The control section 18 may include an isolated interface 22 to electrically isolate an aircraft computer 24 from a power input line 26. A power supply 28 powers the isolated interface 22 and a switch control logic module 30. In one example, the switch control logic module 30 includes a microprocessor 32. A current sensor 34 is configured to measure a flow of current between the power input line 26 and the power section 20, and is operable to transmit this measurement to the switch control logic module 30. The microprocessor 32 is in communication with the current sensor 34 and is operable to control the at least one solid state switch 14. The microprocessor 32 may include a programmable trip function, and is operable to command the at least one solid state switch 14 to change states (e.g., turn from OFF to ON, turn from ON to OFF) in response to the current sensor 34 detecting an overcurrent condition. It is to be appreciated that the microprocessor 32 may be embodied as one or more microprocessors, microcontrollers, digital signal processors, gate arrays, and/or logic circuitry.

The power section 20 includes at least one solid state switch 14. It shall be understood that any type of solid state switch could be used and in one embodiment, the solid state switch is MOSFET switch. A temperature sensor 36 is in communication with the isolated interface 22 and may alert the control section 18 of excessive temperature conditions within the power section 20, for example. A clamping module 38 protects the solid state switch 14 against overvoltage conditions (e.g., lightning, inductive load backfeed, etc.). A secondary protection module 40 protects the load 13 against excessive current conditions.

The current sensor 34 is integrally formed with the control section 18 and serves to provide various components of the control section 18 with information necessary to determine whether the circuit of the solid state switch 14 requires breaking or tripping, thereby performing circuit breaking functionality. The current sensor 34 measures current information from the at least one switch 14 and transmits the current data along a plurality of branches to various components of the power distribution system 10. In addition to transmitting such current data to the switch control logic module 30, as described above, the current data is sent to a current measurement and comparing circuit 50 along input line 52.

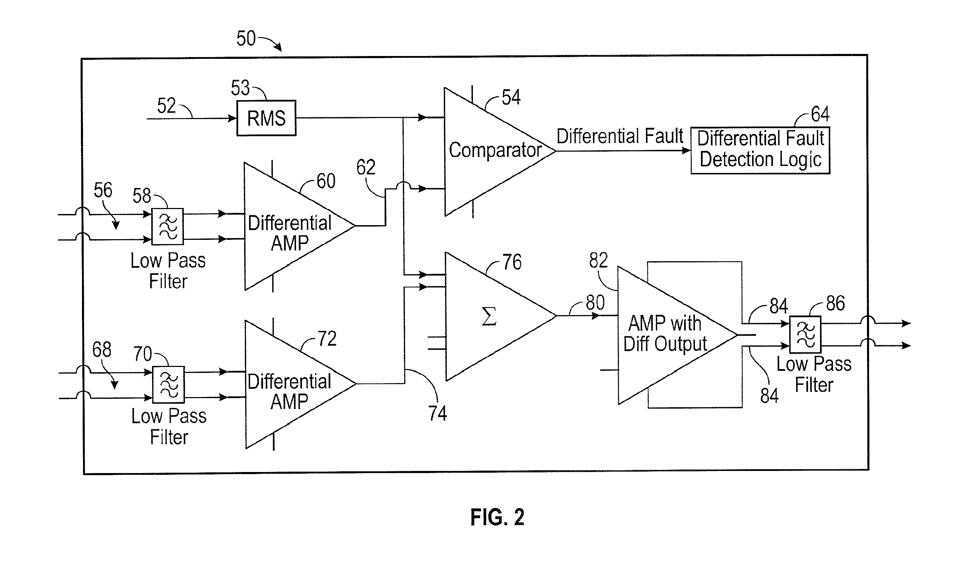

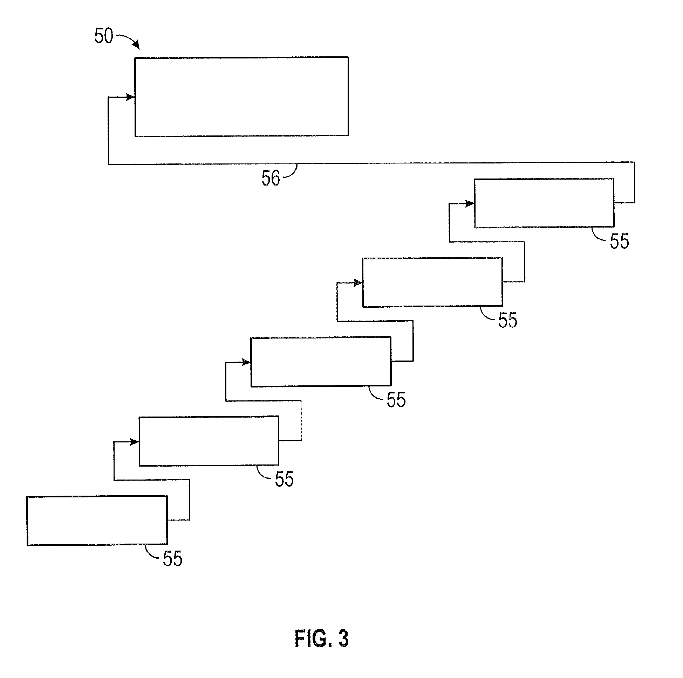

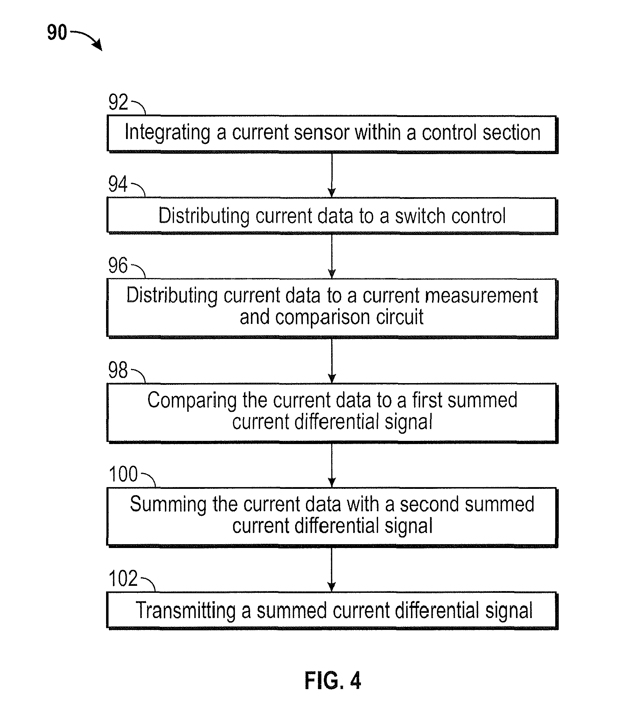

Referring now to FIGS. 2 and 3, the current measurement and comparing circuit 50 is schematically illustrated in detail. The circuit 50 receives current data via input line 52 and converts the current data with a RMS converter 53 to an average root mean square (RMS) value prior to transmitting the current data to a comparator 54. The circuit 50 also receives a first summed current differential signal 56 from at least one, but often a plurality of, downstream solid state switches 55. The first summed current differential signal 56 represents current data from one or more solid state switches that are disposed within the power distribution system 10 and in operable connection with the at least one switch 14. The first summed current differential signal 56 passes through a first low pass filter 58 in order to damp noise, then subsequently through a first differential amplifier 60 that converts the first summed current differential signal 56 to a first single-ended signal 62 prior to transmitting to the comparator 54. The first differential amplifier 60 adapts the scaling factor of the first summed current differential signal 56 to that of the current data transmitted through the input line 52 after passing through the RMS converter 53. The comparator 54 compares the RMS value of the current data received from the input line 52 to that of the first single-ended signal 62. A current difference is determined by, or transmitted to, a fault logic unit 64 and the current difference is compared to a predetermined control magnitude that is selectively determined to account for acceptable current difference tolerances.

The circuit 50 also is configured to receive a second summed current differential signal 68 from at least one, but often a plurality of, solid state switches configured parallel to the at least one solid state switch 14. The second summed current differential signal 68 represents current data from one or more solid state switches that are disposed within the power distribution system 10 and operate neither upstream nor downstream of the at least one solid state switch 14. As will be evident from the description below, it is desirable to bundle the information from all solid state switches in parallel, or at a single level, in order to transmit such information to at least one upstream solid state switch. The second summed current differential signal 68 passes through a second low pass filter 70 in order to damp noise, then subsequently through a second differential amplifier 72 that converts the second summed current differential signal 68 to a second single-ended signal 74. The second single-ended signal 74 is transmitted to a summing logic unit 76. The summing logic unit 76 also receives the current data from the current sensor 34. It is also conceivable that the summing logic unit 76 also receives current data from other sources, however, the function of the summing logic unit 76 will be readily apparent from description of simply the two sources. The summing logic unit 76 combines the signals into a summed current signal 80, thereby representing a summed signal comprising a variety of signals from solid state switches at the same level. The summed current signal 80 is then transmitted to an amplifier 82 for receiving the summed current signal 80 and converting to a summed current differential signal 84 that then passes through a third low pass filter 86. The summed current differential signal 84 may then be transmitted to another solid state switch, such as a solid state switch located upstream, as is the case with the previously discussed first summed current differential signal 56 into the circuit 50. Therefore, the circuit 50 is configured to receive a summed signal containing current data from downstream solid state switches, as well as transmit a summed signal containing current data to upstream solid state switches. In this way, the at least one solid state switch 14 receives information from downstream switches that permits the determination of whether a current "leak" is occurring and also provides information to upstream switches to make a similar determination.

A method 90 of measuring and comparing current of the power distribution system 10 is also provided. The power distribution system 10, and more particularly the current measurement and comparing circuit 50 have been previously described and specific structural components need not be described in further detail. The method 90 includes integrating a current sensor 92 within a control section, where the current sensor is in operable communication with at least one switch. Current data obtained by the current sensor is distributed 94 to a switch control that controls the at least one solid state switch and distributed 96 to the current measurement and comparison circuit via an input line. The circuit compares 98 the current data received from the current sensor via the input line to a first summed current differential signal, as described above. The comparison provides a current difference and if the current difference exceeds a predetermined control magnitude, a fault logic circuit initiates at least one corrective action, such as switching off the at least one solid state switch or providing a message to a control system, which may comprise the microprocessor described above. In addition to the comparison aspect of the method 90, a summing 100 of the current data from the current sensor with other switches at the same level is provided. The summed signal may then be supplied 102 to one or more switches located upstream, where a similar comparison process may occur at the next level.

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

## Claims

1. A current measurement and comparing assembly (12) for a power distribution system (10) comprising:
a solid state contactor module (16) having a control section (18) and a power section (20), wherein the power section includes at least one solid state switch (14); and
a current sensor (34) disposed in the control section (18) and in operable communication with the at least one solid state switch (14), wherein the current sensor (34) distributes current data to a switch control (30) configured to control the at least one solid state switch and distributes current data to a current measurement and comparison circuit (50).

2. The current measurement and comparing assembly of claim 1, wherein the current measurement and comparison circuit (50) comprises:
an input line (52) for transmitting the current data from the current sensor (34) to a comparator (54);
an input for a first summed current differential signal (56) from at least one downstream solid state switch (55); and
a fault logic unit (64) for detecting a difference between the current data from the current sensor and the first summed current signal.

3. The current measurement and comparing assembly of claim 2, the current measurement and comparison circuit (50) further comprising:
a first low pass filter (58) configured to damp noise from the first summed current differential signal (56); and
a differential amplifier (60) for converting the first summed current differential signal (56) to a first single-ended signal (62) prior to transmitting to the comparator.

4. The current measurement and comparing assembly of claim 2 or 3, the current measurement and comparison circuit (50) further comprising a RMS converter (53) configured to convert the current data from the current sensor (34) to an average root mean square value prior to transmitting the current data to the comparator (54).

5. The current measurement and comparing assembly of claim 2, 3 or 4, the current measurement and comparison circuit (50) further comprising:
an input for a second summed current differential signal (68) from at least one parallel switch; and
a summing logic unit (76) for receiving the current data from the current sensor and the second summed current differential signal (68), wherein the summing logic unit distributes a summed current signal (80).

6. The current measurement and comparing assembly of claim 5, the current measurement and comparison circuit (50) further comprising:
a second low pass filter (70) configured to damp noise from the second summed current differential signal (68); and
a differential amplifier (72) for converting the second summed current differential signal (68) to a second single-ended signal (74) prior to transmitting to the summing logic unit (76).

7. The current measurement and comparing assembly of claim 5 or 6, the current measurement and comparison circuit (50) further comprising an amplifier (82) for receiving the summed current signal (80) and transmitting a summed differential signal (84) to at least one upstream solid state switch.

8. The current measurement and comparing assembly of claim 7, the current measurement and comparison circuit (50) further comprising a third low pass filter (86) configured to damp noise from the summed current differential signal (84).

9. The current measurement and comparing assembly of any preceding claim, wherein the power distribution system (10) is disposed on an aircraft.

10. The current measurement and comparing assembly of claim 9, further comprising a microprocessor (32) configured to communicate with the at least one solid state switch (14) and the current sensor (34).

11. A method of measuring and comparing current of a power distribution system (10) comprising:
integrating (92) a current sensor (34) within a control section (18) of a solid state contactor module (16) having at least one solid state switch (14);
distributing (94) current data to a switch control (30) configured to control the at least one solid state switch (14);
distributing (96) current data via an input line (52) to a current measurement and comparison circuit (50); and
comparing (98) the current data received from the input line to a first summed current differential signal (56) from at least one downstream solid state switch (55), wherein a current difference is detected.

12. The method of claim 11, further comprising transmitting the current difference to a fault logic unit (64) for determining whether the current difference is below a predetermined control magnitude; preferably
further comprising initiating a corrective measure if the current difference exceeds the predetermined control magnitude; more preferably
wherein the corrective measure includes at least one of switching off the at least one solid state switch (14) and providing a message to a control system.

13. The method of claim 11 or 12, further comprising transmitting a second summed current differential signal (68) to the current measurement and comparison circuit (50).

14. The method of claim 13, further comprising combining the current data from the input line (52) and the second summed current differential signal (68) to form a summed current signal (80); preferably
further comprising converting the summed current signal to a summed current differential signal; more preferably
further comprising transmitting (102) the summed current differential signal to at least one upstream solid state switch.

15. The method of claim 11, 12, 13 or 14, further comprising disposing the power distribution system (10) on an aircraft.
